# EUROPEAN PATENT SPECIFICATION

(11) **EP 1 432 118 B1**
(45) Date of publication and mention of the grant of the patent: **30.03.2005**
(21) Application number: 03257217.4
(22) Date of filing: 15.11.2003
(51) Int. Cl.: H03B 5/12

(54) **Oscillation circuit for television tuner**
Oszillatorschaltung für einen Fernsehtuner
Circuit oscillateur pour un tuner de television

(30) Priority: 20.11.2002 JP 2002336066
(43) Date of publication of application: 23.06.2004
(73) Proprietor: ALPS ELECTRIC CO., LTD., Ota-ku Tokyo 145 (JP)
(72) Inventor: Yamamoto, Masaki, Ota-ku Tokyo 145 (JP)
(74) Representative: Kensett, John Hinton

(56) References cited:
- EP-A- 0 898 365
- US-A1- 2002 158 695
- ABIDI A A: "CMOS WIRELESS TRANSCEIVERS: THE NEW WAVE" IEEE COMMUNICATIONS MAGAZINE, IEEE SERVICE CENTER. PISCATAWAY, N.J, US, vol. 37, no. 8, August 1999 (1999-08), pages 119-124, XP000835330 ISSN: 0163-6804
- KRAL A ET AL: "RF-CMOS oscillators with switched tuning" CUSTOM INTEGRATED CIRCUITS CONFERENCE, 1998. PROCEEDINGS OF THE IEEE 1998 SANTA CLARA, CA, USA 11-14 MAY 1998, NEW YORK, NY, USA,IEEE, US, 11 May 1998 (1998-05-11), pages 555-558, XP010293959 ISBN: 0-7803-4292-5
- PATENT ABSTRACTS OF JAPAN vol. 2000, no. 26, 1 July 2002 (2002-07-01) & JP 2001 257954 A (ALPS ELECTRIC CO LTD), 21 September 2001 (2001-09-21)

## Description

The invention relates to an oscillation circuit for a television tuner.

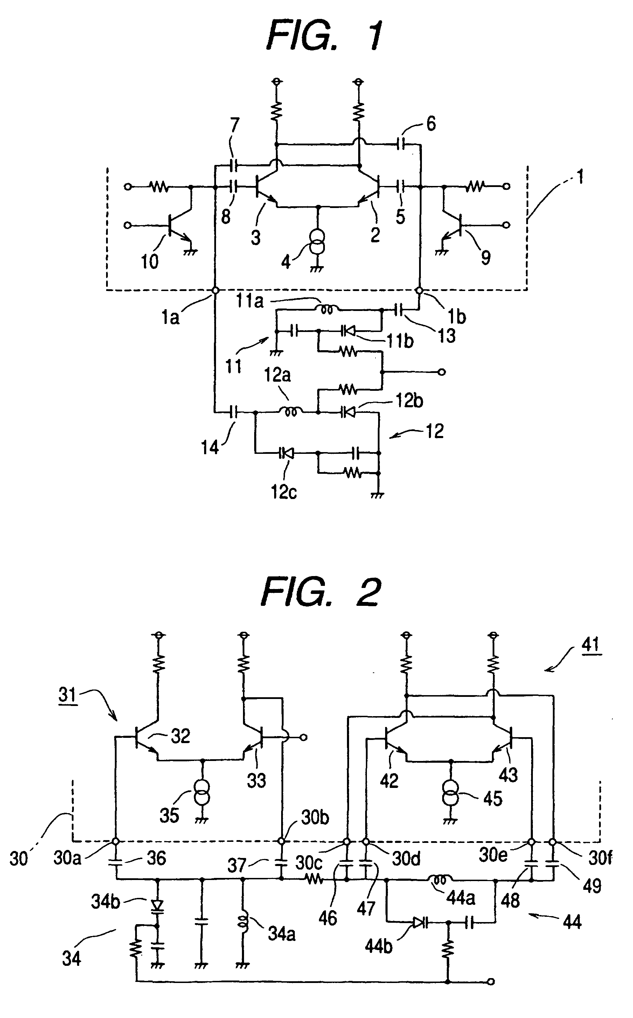

A conventional oscillation circuit for a television tuner is shown in Fig. 2. A first oscillation circuit 31 for a VHF television tuner includes first and second oscillation transistors 32 and 33 formed in an integrated circuit 30, and a first resonance circuit 34 provided outside the integrated circuit 30.

The first and second oscillation transistors 32 and 33 have their emitters connected with each other and then together to a constant current source 35. The second oscillation transistor 33 has its base grounded in terms of high frequencies. The integrated circuit 30 is provided with first and second terminals 30a and 30b, and the first oscillation transistor 32 has its base connected to the first terminal 30a and the second oscillation transistor 33 has its collector connected to the second terminal 30b. The first resonance circuit 34 includes an inductance element 34a, a varactor diode 34b, and the like, and has one end coupled to the first and second terminals 30a and 30b through two coupling capacitors 36 and 37, respectively. The first resonance circuit 34 has its other end grounded.

A second oscillation circuit 41 for a UHF television tuner includes third and fourth oscillation transistors 42 and 43 provided in the integrated circuit 30 and a second resonance circuit 44 provided outside the integrated circuit 30.

The third and fourth oscillation transistors 42 and 43 have their emitters connected to each other and then together to a constant current source 45. The integrated circuit 30 is provided with third to sixth terminals 30c to 30f. The third oscillation transistor 42 has its base connected to the fourth terminal 30d, and the fourth oscillation transistor 43 has its collector connected to the third terminal 30c, the third oscillation transistor 42 has its collector connected to the sixth terminal 30f, and the fourth oscillation transistor 43 has its base connected to the fifth terminal 30e.

The second resonance circuit 44 includes an inductance element 44a, and a varactor diode 44b, and has one end coupled to the third and fourth terminals 30c and 30d through two coupling capacitors 46 and 47, respectively. The second resonance circuit 44 has its other end connected to the fifth and sixth terminals 30e and 30f through two coupling capacitors 48 and 49, respectively.

In this way, the first oscillation circuit 31 forms an unbalanced oscillation circuit and the second oscillation circuit 41 forms a balanced oscillation circuit. An oscillation frequency is set based on tuning voltage applied to the varactor diodes 34b and 44b (see, for example, JP-A-2001-257954 (fig.1)).

In the above configuration, two oscillation transistors are used in each of the oscillation circuits. Since these oscillation circuits oscillate at high frequency, the oscillation transistors must have a high transition frequency fT, which raises the cost. In addition, the transistor of this type has a large chip size and increases the size of an integrated circuit when it is provided in the integrated circuit. The terminals connected to the collectors and bases of the transistors are provided in the integrated circuit, then the resonance circuits are connected to the terminals, and therefore the number of terminals in the integrated circuit increases, which also increases the size of the integrated circuit.

It is an object of the present invention to reduce the number of oscillation transistors for decreasing the cost, and to reduce the size even when the elements are formed into an integrated circuit.

According to the invention, there is provided an oscillation circuit comprising first and second oscillation transistors differentially connected having their emitters connected with each other, and first and second resonance circuits, said first resonance circuit has one end coupled to the base of said first oscillation transistor and the collector of said second oscillation transistor and its other end grounded, said second resonance circuit has one end coupled to the collector of said first oscillation transistor and the base of said second oscillation transistor and its other end grounded, first switch means is connected between one end of said first resonance circuit and ground, second switch means is connected between one end of said second resonance circuit and ground, and said first and second switch means turn on/off reversely from each other.

Furthermore, said first and second oscillation transistors and said first and second switch transistors are provided in the integrated circuit, said integrated circuit is provided with first and second terminals, the base of said first oscillation transistor and the collector of said second oscillation transistor are coupled to said first terminal through corresponding coupling capacitors provided in said integrated circuit, and the collector of said first oscillation transistor and the base of said second oscillation transistor are coupled to said second terminal through corresponding coupling capacitors provided in said integrated circuit.

Furthermore, said first and second switch means are each made of a switch transistor, and said first and second switch transistors are provided in said integrated circuit.

Furthermore, said first and second oscillation transistors and said first resonance circuit form an oscillation circuit for a VHF television tuner, and said first and second oscillation transistors and said second resonance circuit form an oscillation circuit for a UHF television tuner.

An embodiment of the present invention will now be described, by way of example, with reference to the accompanying diagrammatic drawings, in which:
Fig. 1 is a circuit diagram of the configuration of an oscillation circuit for a television tuner according to the invention.
Fig. 2 is a circuit diagram of the configuration of a conventional oscillation circuit for a television tuner.

Fig. 1 shows an oscillation circuit for a television tuner according to the invention. In an integrated circuit 1, first and second oscillation transistors 2 and 3 are formed. The two oscillation transistors 2 and 3 have their emitters connected with each other and then together to a constant current source 4. First and second terminals 1a and 1b are provided in the integrated circuit 1. The base of the first oscillation transistor 2 and the collector of the second oscillation transistor 3 are connected to the first terminal 1b through coupling capacitors 5 and 6, respectively provided in the integrated circuit 1. The collector of the first oscillation transistor 2 and the base of the second oscillation transistor 3 are connected to the second terminal 1a through coupling capacitors 7 and 8, respectively provided in the integrated circuit 1.

First and second switch means 9 and 10 are provided in the integrated circuit 1, the first switch means 9 is connected between the first terminal 1b and ground, and the second switch means 10 is connected between the second terminal 1a and ground. The first and second switch means 9 and 10 are made of switch transistors, each of which has a collector provided with bias voltage and an emitter grounded. It turns on/off in response to the presence/absence of the bias voltage to the base. The switch transistors need only to turn on/off in a DC manner, and therefore may be inexpensive kinds. In this way, the chip size can be reduced.

First and second resonance circuits 11 and 12 are provided outside the integrated circuit 1. The first resonance circuit 11 includes an inductance element 11a, a varactor diode 11b connected in parallel with the inductance element 11a, and the like, and has one end connected to the first terminal 1b through a DC cut capacitor 13 and its other end grounded. The varactor diode 11b has its anode grounded in a DC manner.

The second resonance circuit 12 has an inductance element 12a and a varactor diode 12b connected in series with each other, a varactor diode 12c connected in parallel to the series circuit, and the like. The second resonance circuit 12 has one end connected to the second terminal 1a through a DC cut capacitor 14 and its other end grounded. The two varactor diodes 12b and 12c have their anodes grounded in a DC manner. Tuning voltage is applied to the cathodes of the three varactor diodes 11b, 12b, and 12c.

In the above-described configuration, the two switch means 9 and 10 are controlled so that they turn on/off reversely from each other.

When the first switch means 9 is off, the second switch means 10 is on. Consequently, the second resonance circuit 12 has both ends grounded, and the two oscillation transistors 2 and 3, and the first resonance circuit 11 form an unbalanced oscillation circuit. The oscillation circuit is used for a VHF tuner.

When the first switch means 9 is on, the second switch means 10 is off. Consequently, the first resonance circuit 11 has both ends grounded, and the two oscillation transistors 2 and 3, and the second resonance circuit 12 form an unbalanced oscillation circuit. The oscillation circuit is used for a UHF tuner.

In this way, the two oscillation transistors 2 and 3 are shared by the two resonance circuits 11 and 12, so that the number of the oscillation transistors can be half that of the case when oscillation is caused separately in the two frequency bands.

Furthermore, when the two oscillation transistors 2 and 3 are provided in the integrated circuit 1, the oscillation transistors 2 and 3 have their collectors and bases connected to the first terminals 1a and 1b through the coupling capacitors 5 to 8, so that the number of terminals can be small.

As in the foregoing, the first resonance circuit has one end coupled to the base of the first oscillation transistor and the collector of the second oscillation transistor and its other end grounded, the second resonance circuit has one end coupled to the collector of the first oscillation transistor and the base of the second oscillation transistor and its other end grounded, the first switch means is connected between one end of the first resonance circuit and ground, the second switch means is connected between one end of the second resonance circuit and ground, and the first and second switch means turn on/off reversely from each other, so that the two oscillation transistors are shared by the two resonance circuits, and the number of the oscillation transistors can be half the number otherwise necessary when oscillation is caused separately in the two frequency bands. Consequently, the cost can be reduced.

In addition, the first and second oscillation transistors and the first and second switch transistors are provided in the integrated circuit, the integrated circuit is provided with the first and second terminals, the base of the first oscillation transistor and the collector of the second oscillation transistor are coupled to the first terminal through the corresponding coupling capacitors provided in the integrated circuit, and the collector of the first oscillation transistor and the base of the second oscillation transistor are coupled to the second terminal through the corresponding coupling capacitors provided in the integrated circuit. Therefore, when the two oscillation transistors 2 and 3 are provided in the integrated circuit 1, the collectors and bases of the oscillation transistors 2 and 3 are connected to the first terminals 1a and 1b through the corresponding coupling capacitors 5 to 8, and the number of terminals canbe reduced. Consequently, the size of the integrated circuit can be reduced.

In addition, the first and second switch means are made of switch transistors, and first and second switch transistors are provided in the integrated circuit, so that the size and cost of the integrated circuit can be reduced.

Furthermore, an oscillation circuit for a VHF television tuner is made of the first and second oscillation transistors and the first resonance circuit, while an oscillation circuit for a UHF television tuner is made of the first and second oscillation transistors and the second resonance circuit. Therefore, the UHF television tuner and the VHF television turner can be provided using the two oscillation transistors.

## Claims

1. An oscillation circuit for a television tuner, comprising first and second oscillation transistor differentially connected having their emitters connected with each other, and first and second resonance circuits, wherein said first resonance circuit has one end coupled to the base of said first oscillation transistor and the collector of said second oscillation transistor and its other end grounded, said second resonance circuit has one end coupled to the collector of said first oscillation transistor and the base of said second oscillation transistor and its other end grounded, first switch means is connected between one end of said first resonance circuit and ground, second switch means is connected between one end of said second resonance circuit and ground, and said first and second switch means turn on/off reversely from each other.

2. The oscillation circuit for a television tuner according to claim 1, wherein
said first and second oscillation transistors and said first and second swith transistors are provided in the integrated circuit, said integrated circuit is provided with first and second terminals, the base of said first oscillation transistor and the collector of said second oscillation transistor are coupled to said first terminal through corresponding coupling capacitors provided in said integrated circuit, and the collector of said first oscillation transistor and the base of said second oscillation transistor are coupled to said second terminal through corresponding coupling capacitors provided in said integrated circuit.

3. The oscillation circuit for a television tuner according to claim 1 or 2, wherein
said first and second switch means are each made of a switch transistor, and said first and second switch transistors are provided in said integrated circuit.

4. The oscillation circuit for a television tuner according to claim 1, 2, or 3, wherein
said first and second oscillation transistors and said first resonance circuit form an oscillation circuit for a VHF television tuner, and said first and second oscillation transistors and said second resonance circuit form an oscillation circuit for a UHF television tuner.

## Patentansprüche

1. Eine Oszillationsschaltung für einen Fernsehtuner, aufweisend einen ersten und zweiten Oszillationstransistor, die in Differenzschaltung miteinander verbunden sind und deren Emitter miteinander verbunden sind, und eine erste und eine zweite Resonanzschaltung, wobei ein Ende der besagten ersten Resonanzschaltung mit der Basis des besagten ersten Oszillationstransistors und dem Kollektor des besagten zweiten Oszillationstransistors gekoppelt und ihr anderes Ende masseverbunden ist, wobei ein Ende der besagten zweiten Resonanzschaltung mit dem Kollektor des besagten ersten Oszillationstransistors und der Basis des besagten zweiten Oszillationstransistors gekoppelt und ihr anderes Ende masseverbunden ist, wobei eine erste Schalteinrichtung zwischen ein Ende der besagten ersten Resonanzschaltung und Masse geschaltet ist und eine zweite Schalteinrichtung zwischen ein Ende der besagten zweiten Resonanzschaltung und Masse geschaltet ist und besagte erste und zweite Schalteinrichtung umgekehrt zueinander ein/ausschalten.

2. Oszillationsschaltung für einen Fernsehtuner nach Anspruch 1, wobei
sich besagter erster und zweiter Oszillationstransistor und besagter erster und zweiter Schalttransistor in der integrierten Schaltung befinden, besagte integrierte Schaltung mit einem ersten und zweiten Anschluss versehen ist, die Basis des besagten ersten Oszillationstransistors und der Kollektor des besagten zweiten Oszillationstransistors über entsprechende in der integrierten Schaltung vorgesehene Koppelkondensatoren mit besagtem ersten Anschluss gekoppelt sind und der Kollektor des besagten ersten Oszillationstransistors und die Basis des besagten zweiten Oszillationstransistors über entsprechende in der integrierten Schaltung vorgesehene Koppelkondensatoren mit besagtem zweiten Anschluss gekoppelt sind.

3. Oszillationsschaltung für einen Fernsehtuner nach Anspruch 1 oder 2, wobei
besagte erste und besagte zweite Schalteinrichtung je aus einem Schalttransistor gemacht sind und besagter erster und besagter zweiter Schalttransistor sich in besagter integrierter Schaltung befinden.

4. Oszillationsschaltung für einen Fernsehtuner nach Anspruch 1, 2 oder 3, wobei
besagter erster und zweiter Oszillationstransistor und besagte erste Resonanzschaltung eine Oszillationsschaltung für einen VHF-Fernsehtuner bilden und besagter erster und zweiter Oszillationstransistor und besagte zweite Resonanzschaltung eine Oszillationsschaltung für einen UHF-Fernsehtuner bilden.

## Revendications

1. Circuit oscillant d'un sélecteur de canaux de télévision, comprenant un premier et un second transistors montés en oscillateurs à connexion différentielle ayant leurs émetteurs connectés entre eux et un premier et un second circuits résonants, dans lesquels ledit premier circuit résonant a une extrémité couplée à la base dudit premier transistor monté en oscillateur et au collecteur dudit second transistor monté en oscillateur, et son autre extrémité mise à la terre, et ledit second circuit résonant a une extrémité couplée au collecteur dudit premier transistor monté en oscillateur et à la base dudit second transistor monté en oscillateur, et son autre extrémité mise à la terre, un premier moyen de commutation connecté entre une extrémité dudit premier circuit résonant et la terre, un second moyen de commutation connecté entre une extrémité dudit second circuit résonant et la terre, lesdits premier et second moyens de commutation s'activant/se désactivant inversement l'un par rapport à l'autre.

2. Circuit oscillant d'un sélecteur de canaux de télévision selon la revendication 1, dans lequel
lesdits premier et second transistors montés en oscillateurs et lesdits premier et second moyens de commutation sont prévus dans le circuit intégré, ledit circuit intégré est équipé d'une première et d'une seconde bornes, la base dudit premier transistor monté en oscillateur et le collecteur dudit second transistor monté en oscillateur sont couplés à ladite première borne via des condensateurs de liaison correspondants prévus dans ledit circuit intégré, et le collecteur dudit premier transistor monté en oscillateur et la base dudit second transistor monté en oscillateur sont couplés à ladite seconde borne via les condensateurs de liaison correspondants prévus dans ledit circuit intégré.

3. Circuit oscillant d'un sélecteur de canaux de télévision selon la revendication 1 ou 2, dans lequel
lesdits premier et second moyens de commutation sont chacun constitués d'un transistor de commutation, et lesdits premier et second transistors de commutation sont prévus dans ledit circuit intégré.

4. Circuit oscillant d'un sélecteur de canaux de télévision selon la revendication 1, 2 ou 3, dans lequel
lesdits premier et second transistors montés en oscillateurs et ledit premier circuit résonant forment un circuit oscillant d'un sélecteur de canaux de télévision VHF, et lesdits premier et second transistors montés en oscillateurs et ledit second circuit résonant forment un circuit oscillant d'un sélecteur de canaux de télévision UHF.
